# FASCICULE DE BREVET EUROPEEN

(11) **EP 2 149 886 B1**
(45) Date de publication et mention de la délivrance du brevet: **06.06.2012**
(21) Numéro de dépôt: 09165996.1
(22) Date de dépôt: 21.07.2009
(51) Int. Cl.: G11C 29/38, G01R 31/3185, H03K 3/037, H03K 3/3562

(54) **Protection d'un circuit électronique à bascules contre des injections de fautes**
Schutz einer elektronischen Kippschaltung gegen Fehlereingaben
Protection of an electronic trigger circuit against fault injections

(30) Priorité: 30.07.2008 FR 0855256
(43) Date de publication de la demande: 03.02.2010
(73) Titulaire: STMicroelectronics (Rousset) SAS, 13790 Rousset (FR)
(72) Inventeur: Bancel, Frédéric, 13560 Senas (FR); Roquelaure, Philippe, 13320 Bouc Bel Air (FR)
(74) Mandataire: de Beaumont, Michel

(56) Documents cités:
- EP-A- 0 418 521
- US-A- 5 703 513
- US-B1- 6 630 853

## Description

### Domaine de l'invention

La présente invention concerne de façon générale les circuits électroniques et, plus particulièrement, les circuits contenant des bascules synchrones. L'invention s'applique plus particulièrement à la détection d'une éventuelle perturbation dans un chemin logique de traitement de données incluant une ou plusieurs bascules synchrones, que cette perturbation soit accidentelle ou volontaire.

### Exposé de l'art antérieur

Dans de nombreux circuits électroniques, des bascules de synchronisation sont utilisées entre des blocs de portes logiques pour créer des éléments de mémorisation de valeurs (par exemple des registres, des compteurs, etc.). Il est alors souhaitable que les états binaires manipulés par les bascules soient fiables. Or, des perturbations accidentelles ou volontaires intervenant sur le circuit électronique (par exemple des pics d'alimentation, des impulsions laser, etc.) peuvent affecter les données manipulées par les bascules de synchronisation. On distingue des effets statiques et dynamiques. Les effets statiques proviennent essentiellement de perturbations volontaires (par exemple, des attaques laser) et modifient directement l'état interne d'une bascule sans intervenir sur le rythme des signaux. Les effets dynamiques provoquent une erreur dans la capture de la donnée en entrée d'une bascule et peuvent provenir de perturbations accidentelles et volontaires. Ces effets dynamiques sont liés aux caractéristiques intrinsèques des bascules de synchronisation qui requièrent qu'une donnée soit présente sur l'entrée de données suffisamment longtemps avant un front déclencheur d'une mémorisation (temps de prise en compte - setup time) et reste présente suffisamment longtemps après ce front déclencheur (temps de maintien - hold time). Accélérer un signal déclencheur (typiquement un signal d'horloge) ou retarder la donnée peut entraîner que l'acquisition ne respecte pas le temps de prise en compte. Ralentir le signal d'horloge ou accélérer la donnée peut entraîner que le temps de maintien ne soit pas respecté.

De telles perturbations sont particulièrement critiques dans des circuits électroniques manipulant des données que l'on souhaite protéger contre un accès non autorisé (par exemple des clés ou algorithmes de chiffrement ou des données censées rester secrètes).

Le document US 6,630,853 B1 décrit un procédé selon le préambule de la revendication 1 et un circuit électronique selon le préambule de la revendication 6.

### Résumé

Il serait souhaitable de pouvoir détecter que les données d'une ou plusieurs bascules de synchronisation ont subi des perturbations accidentelles ou volontaires, que cette perturbation soit d'origine dynamique ou statique.

Il serait également souhaitable de rendre cette détection possible pour toutes les bascules d'un circuit ou au moins pour celles manipulant des données considérées comme sensibles.

Il serait également souhaitable de pouvoir choisir, au sein d'un même circuit ou processus de fonctionnement, des périodes d'activation et de désactivation de la protection.

Pour atteindre tout ou partie de ces objets ainsi que d'autres, il est prévu un procédé de détection d'une perturbation de l'état d'une bascule synchrone de type maître-esclave comportant deux circuits bistables en série, selon la revendication 1.

Selon un mode de réalisation de la présente invention, les deuxièmes signaux sont échantillonnés sur des fronts des premiers signaux.

Selon un mode de réalisation de la présente invention, les premiers signaux sont générés de telle sorte que les circuits bistables sont commandés cycliquement en quatre périodes successives dans lesquelles :
les deux circuits sont verrouillés ;
seul un premier circuit est verrouillé ;
les deux circuits sont verrouillés ; et
seul un deuxième circuit est verrouillé.

Selon un mode de réalisation de la présente invention, les périodes où les deux circuits sont verrouillés fournissent, sur les deuxièmes signaux, des états indicateurs d'une perturbation éventuelle.

Selon un mode de réalisation de la présente invention, un niveau constant d'un des premiers signaux désactive la détection.

Il est également prévu un circuit électronique selon la revendication 6.

Selon un mode de réalisation de la présente invention, un deuxième circuit logique est intercalé entre les deux bornes d'application des signaux déclencheurs et des bornes de déclenchement respectives des circuits bistables.

Selon un mode de réalisation de la présente invention, le premier circuit logique comporte deux comparateurs comparant respectivement le niveau de l'entrée de la bascule au niveau du point intermédiaire, et le niveau du point intermédiaire au niveau de la sortie de la bascule.

Selon un mode de réalisation de la présente invention, le deuxième circuit logique comporte :
une porte de type OU dont les entrées respectives sont reliées aux bornes d'application des signaux déclencheurs et dont une sortie est reliée à la borne de déclenchement du premier circuit bistable ; et
un inverseur entre une des bornes d'application des signaux déclencheurs et la borne de déclenchement du deuxième circuit bistable.

Il est également prévu un circuit électronique incluant au moins un bloc de combinaisons logiques et au moins un ensemble de bascules synchrones maître-esclave.

Selon un mode de réalisation de la présente invention, toutes les bascules ne sont pas commandées en même temps en mode comparaison.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une représentation schématique d'une bascule maître-esclave dans un exemple d'environnement ;
la figure 2 est un schéma-blocs d'une bascule maître-esclave ;
la figure 3 est un schéma électrique plus détaillé d'un exemple de réalisation d'une bascule maître-esclave ;
les figures 4A, 4B, 4C, 4D, 4E, 4F, 4G, 4H, 4I et 4J illustrent, par des chronogrammes, le fonctionnement de la bascule de la figure 3 ;
la figure 5 représente le schéma électrique d'un autre exemple de bascule maître-esclave ;
la figure 6 est un schéma-blocs d'un mode de réalisation d'une bascule maître-esclave capable de détecter une éventuelle perturbation ;
la figure 7 est un schéma-blocs plus détaillé d'un mode de réalisation de la bascule maître-esclave de la figure 6 ;
les figures 8A, 8B, 8C, 8D et 8E sont des chronogrammes illustrant le fonctionnement de la bascule maître-esclave de la figure 7 ;
la figure 9 représente un mode de réalisation d'un circuit d'exploitation de la détection opérée par plusieurs bascules maître-esclave ; et
la figure 10 illustre un exemple de système incluant un circuit intégré équipé de bascules à détection de perturbation.

De mêmes éléments ont été désignés par de mêmes références aux différentes figures, dont les chronogrammes ont été tracés sans respect d'échelle.

### Description détaillée

Pour des raisons de clarté, seuls les éléments utiles à la compréhension de l'invention ont été représentés et seront décrits. En particulier, les circuits en amont et en aval des bascules auxquelles s'applique la présente invention n'ont pas été détaillés, l'invention étant compatible avec tout circuit logique usuel. De plus, les circuits exploitant les détections opérées n'ont pas non plus été détaillées, l'invention étant là encore compatible avec toute contre mesure usuelle en cas de détection d'une perturbation (par exemple, arrêt du circuit, blocage des ports de sortie, réinitialisation, alerte, etc.).

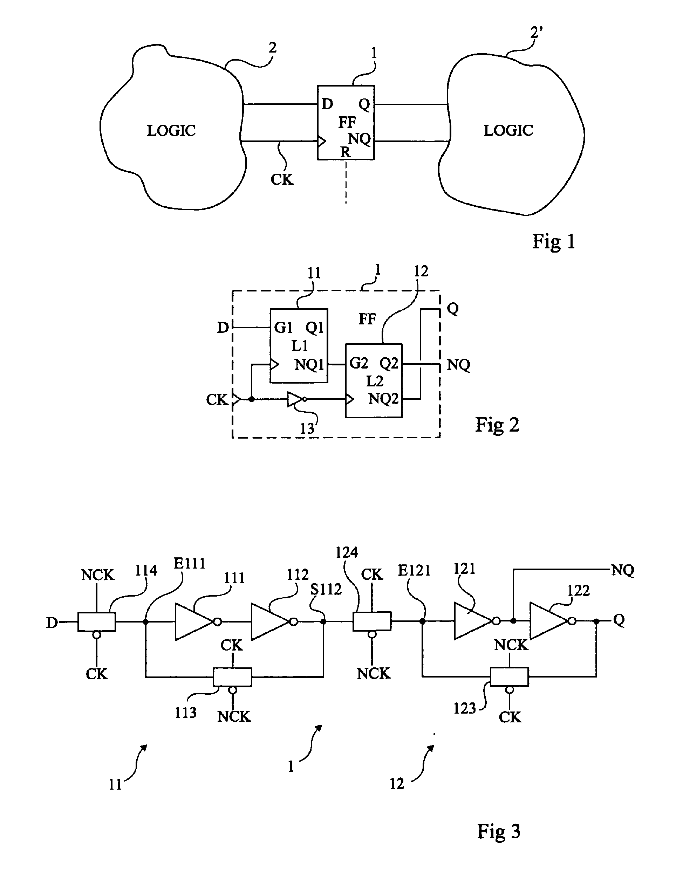

La figure 1 représente schématiquement une bascule synchrone de mémorisation 1 de type maître-esclave (bascule D ou D flip-flop) dans un exemple d'environnement. Typiquement, la bascule 1 est associée en amont à des éléments logiques 2 (LOGIC) et en aval à d'autres éléments de traitement logiques 2'. La bascule 1 comporte une entrée de données D et des sorties Q directe et NQ inversée, ainsi qu'une borne d'application d'un signal déclencheur ou d'horloge. Parfois, une entrée de réinitialisation R permet d'initialiser l'état de la bascule, par exemple à la mise sous tension du circuit. La bascule de mémorisation 1 peut, selon sa configuration, être déclenchée sur front montant ou sur front descendant du signal CK. Dans une version sur front montant, la sortie Q recopie l'entrée D à chaque front montant du signal CK.

la figure 2 illustre, sous forme de blocs, la structure d'une bascule D maître-esclave 1 usuelle. Une telle bascule associe deux circuits bistables 11 et 12 de type verrou transparent (latch) que l'on désigne aussi parfois par bascule. Chaque circuit 11, 12 comporte une entrée de données G1, G2, une borne de déclenchement et des sorties Q1, Q2 directes et NQ1, NQ2 inverses. Le bistable 11 constitue le circuit maître et le bistable 12 le circuit esclave de la bascule maître-esclave 1.

L'entrée D de données de la bascule 1 est reliée à l'entrée de données G1 du premier bistable 11. La sortie inverse NQ1 du circuit 11 est reliée à l'entrée de données G2 du circuit 12. La sortie Q2 du circuit 12 définit la sortie inverse NQ de la bascule 1 tandis que la sortie inverse NQ2 du circuit 12 en définit la sortie directe Q. Les bornes de déclenchement des circuits 11 et 12 reçoivent, dans une bascule maître-esclave classique, un signal d'horloge commun. Ce signal déclencheur est adressé directement au premier circuit bistable 11 et est inversé (inverseur 13) pour être envoyé sur le deuxième circuit bistable 12. Dans d'autres bascules, l'entrée G2 est reliée à la sortie Q1 et la sortie Q est prélevée sur la sortie Q2.

La figure 3 représente une bascule maître-esclave 1 du type de celle représentée en figure 2 en détaillant un exemple de constitution des circuits bistables 11 et 12. Chaque circuit 11, 12 est formé de deux inverseurs 111 et 112, respectivement 121 et 122 en série. La sortie de chaque deuxième inverseur 112, 122 est rebouclée sur l'entrée du premier 111, 121 par l'intermédiaire d'un commutateur 113, 123. Les entrées respectives des premiers inverseurs 111 et 121 sont connectées à un commutateur 114, 124. Les commutateurs 113, 114, 123 et 124 sont tous commandés à partir d'un même signal d'horloge CK et sont des commutateurs à trois états (état passant, état bloqué et état de haute impédance). Les commutateurs 113 et 124 sont passants quand le signal CK est à l'état 1 et sont bloqués quand il est à l'état 0 (signal inverse NCK à l'état haut) tandis que les commutateurs 114 et 123 sont à l'inverse passants lorsque le signal CK est à l'état bas. L'entrée D de la bascule maître-esclave correspond à l'entrée de l'interrupteur 114 et ses sorties Q et NQ correspondent respectivement aux sorties des inverseurs 122 et 121.

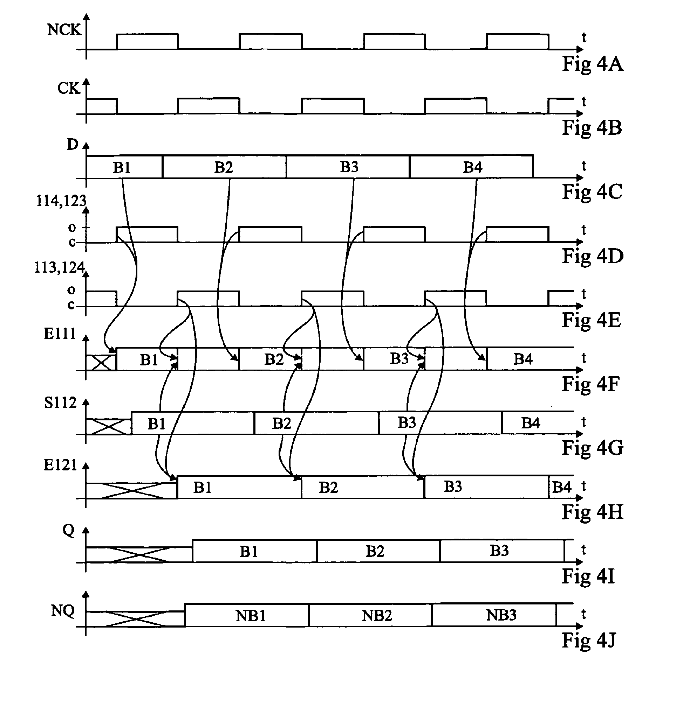

Les figures 4A, 4B, 4C, 4D, 4E, 4F, 4G, 4H, 4I et 4J illustrent, par des chronogrammes, le fonctionnement d'une bascule maître-esclave du type de celle représentée en figure 3. Ces figures représentent respectivement des exemples d'allures de signaux appliqués sur les bornes NCK, CK et D, d'états des interrupteurs 114 et 123, d'états des interrupteurs 113 et 124, du signal présent en entrée E111 de l'inverseur 111, du signal présent en sortie S112 de l'inverseur 112 (correspondant à la borne de sortie NQ1 ou à la borne d'entrée G2), du signal présent en entrée E121 de l'inverseur 121, de la sortie directe Q et de la sortie inverse NQ.

Ces figures illustrent le traitement par la bascule 1 de bits B1, B2, B3 et B4 du signal de données présenté en entrée D. Pour simplifier, on suppose que les bits de données sont chacun présents pendant une période complète du signal d'horloge. Ces figures illustrent qu'un bit de données est fourni par la bascule avec une période de retard par rapport à son entrée. Dans une première demi période, la donnée présente à l'entrée est mémorisée par le premier circuit bistable 11 alors que, dans une deuxième demi période, il est transféré vers le deuxième circuit bistable 12 où il est mémorisé. Aux figures 4G, 4I et 4J, on a exagéré les décalages temporels liés aux temps de propagation dans les inverseurs.

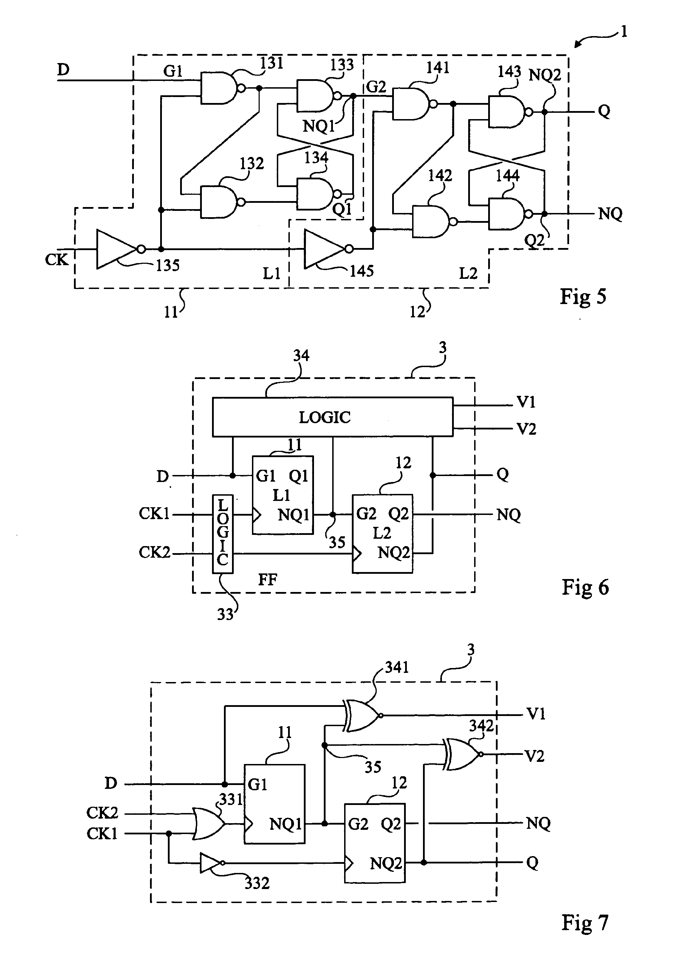

La figure 5 représente le schéma électrique d'un deuxième exemple de bascule maître-esclave 1 dans lequel les circuits bistables 11 et 12 sont réalisés sous la forme de portes logiques de type NON-ET. Chaque circuit bistable comporte quatre portes 131, 132, 133 et 134, respectivement 141, 142, 143 et 144, et un inverseur 135, respectivement 145. Une entrée d'une première porte 131, 141 définit l'entrée de données G1, G2 du circuit bistable. La sortie de cette porte est reliée à une première entrée de la porte 132 ou 142. Les deuxièmes entrées respectives des portes 131 et 132, respectivement 141 et 142, sont reliées en sortie de l'inverseur 135, respectivement 145, pour recevoir l'inverse du signal d'horloge CK. Les sorties respectives des portes 131 et 132, respectivement 141 et 142, sont reliées à une première entrée de la porte 133, respectivement 143, dont la deuxième entrée est reliée à la sortie de la porte 134, respectivement 144. La sortie de la porte 133, 143 est reliée à l'autre entrée de la porte 134, 144. Les sorties des portes 133 et 134, respectivement 143 et 144 définissent les sorties directes Q1 et Q2, respectivement inverses NQ1 et NQ2 des circuits bistables. Le fonctionnement de la bascule de la figure 5 se déduit de sa structure.

Pour réaliser des bascules maître-esclave sur front descendant, il suffit d'inverser les signaux d'horloge.

La figure 6 est un schéma-blocs d'un mode de réalisation d'une bascule maître-esclave 3 à détection de perturbation. On retrouve les deux circuits bistables 11 et 12 qui sont, à l'exception de leurs bornes de déclenchement, câblés à la manière d'une bascule maître-esclave usuelle.

Les bornes de déclenchement des circuits 11 et 12 reçoivent des signaux distincts, fournis soit directement depuis l'extérieur, soit mis en forme par un bloc logique 33 (LOGIC) recevant deux signaux déclencheurs appliqués sur des bornes CK1 et CK2 de la bascule 3.

La détection d'une éventuelle perturbation de la donnée est obtenue grâce à un circuit logique 34 (LOGIC) qui interprète (combine) les états respectifs de l'entrée D, de la sortie Q et du point de transmission 35 entre les deux circuits bistables. Ce point 35 correspond donc à la valeur de sortie NQ1 du circuit bistable 11 et à l'entrée G2 du circuit bistable 12.

Le principe mis en oeuvre est de créer une fenêtre temporelle pendant laquelle on considère que la logique combinatoire doit être stable, et de créer des points de référence au sein même de la bascule maître-esclave pour vérifier les valeurs d'entrée, de sortie et intermédiaire.

La figure 7 représente un exemple de réalisation d'une bascule maître-esclave 3 dans laquelle les circuits logiques 33 et 34 ont été détaillés. Les signaux déclencheurs appliqués sur les bornes CK1 et CK2 sont combinés par une porte de type OU 331 dont la sortie est reliée à la borne de déclenchement du premier circuit bistable 11. La borne CK2 est par ailleurs reliée, après traversée d'un inverseur 332, à la borne de déclenchement du circuit bistable 12.

Le circuit d'interprétation 34 comporte deux portes de type NON-OU Exclusif 341 et 342 comparant la valeur (0 ou 1) présente au point central 35, respectivement avec la valeur de l'entrée D et avec la valeur de la sortie Q. Les sorties respectives des portes 341 et 342 fournissent deux signaux de validation (ou d'invalidation) V1 et V2 indicateurs d'une perturbation respectivement dynamique ou statique.

Le rôle de la porte 331 est d'activer ou non le mécanisme de détection au sein de la bascule. Si la bascule doit détecter en permanence d'éventuelles perturbations, cette porte peut être omise. Les signaux CK1 et CK2 sont alors directement générés par un circuit de commande et l'inverseur 332 peut alors également être omis.

La présence de la porte 331 permet de sélectionner des plages de fonctionnements (par exemple, des périodes manipulant des données sensibles du point de vue de la sécurité) dans lesquelles on s'assure de l'absence de perturbation et des plages dans lesquelles la détection est inactive. Pour désactiver la détection, le signal déclencheur appliqué sur la borne CK2 est maintenu à l'état bas. Le signal déclencheur appliqué sur la borne CK1 est alors envoyé sur l'entrée d'horloge du circuit 11 tandis que son inverse est envoyé sur l'entrée d'horloge du circuit 12. La bascule fonctionne dans ce cas de la même façon qu'une bascule usuelle (figure 2). Pour un fonctionnement avec détection, les signaux déclencheurs sont générés pour produire quatre périodes cycliques au cours desquelles successivement :
les deux circuits 11 et 12 sont verrouillés (latched) ;
le circuit 11 est verrouillé tandis que le circuit 12 laisse passer la donnée (présente au point intermédiaire 35) ;
les deux circuits 11 et 12 sont verrouillés ; et
le circuit 11 laisse passer la donnée tandis que le circuit 12 est verrouillé.

Cela revient à ajouter au deux états passant/verrouillé et verrouillé/passant d'une bascule maître-esclave usuelle, un état dans lequel les deux circuits bistables sont verrouillés. On allonge ainsi les transitions entre les états passant/verrouillé et verrouillé/passant par l'ajout d'états verrouillé/verrouillé, alors que dans les bascules maître-esclave usuelles, les transitions doivent être rapides pour que la bascule fonctionne correctement.

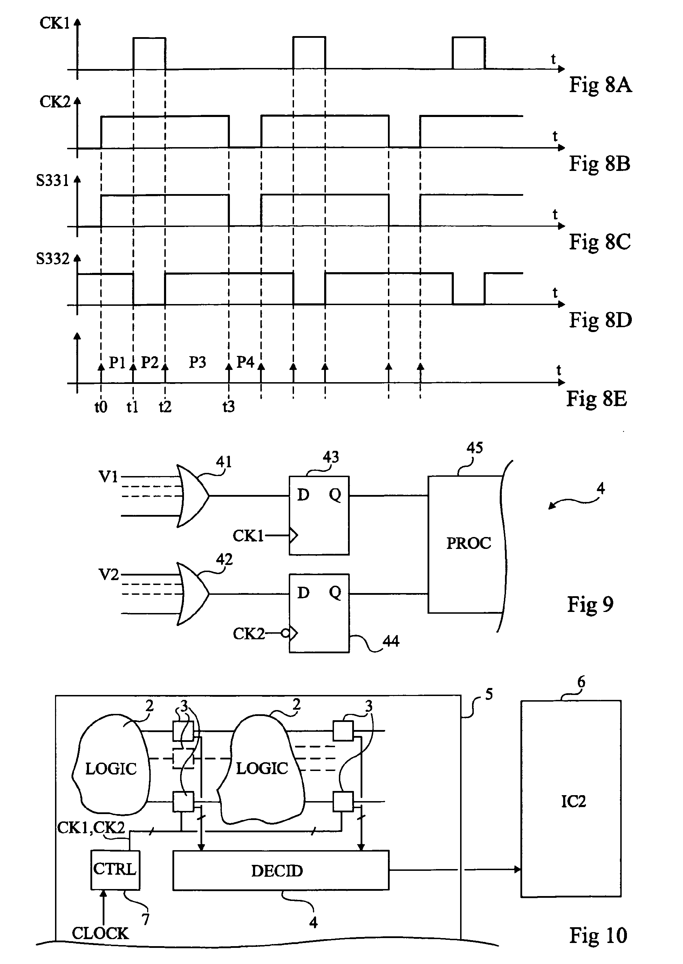

Les figures 8A, 8B, 8C, 8D et 8E sont des chronogrammes illustrant le fonctionnement de la bascule maître-esclave des figures 6 et 7. Ces figures représentent des exemples d'allure respectivement des signaux déclencheurs appliqués sur les bornes CK1 et CK2, du signal de sortie S331 de la porte 331 (signal déclencheur du circuit 11), de la sortie S332 de l'inverseur 332 (signal déclencheur du circuit 12), et des fenêtres de transfert de la donnée au sein de la bascule maître-esclave. Pour simplifier, on confond dans ce qui suit les bornes CK1, CK2, S331, S332 et les signaux déclencheurs correspondants.

Dans une première période P1 (signal CK1 à l'état bas et signal CK2 à l'état haut), les signaux S331 et S332 sont tous deux à l'état haut. Au front montant (instant t0) du signal S331 (front montant du signal CK2) qui débute cette période P1, le circuit bistable 11 mémorise la valeur présente sur son entrée de données (donc la donnée en entrée de la bascule) et se verrouille sur cette valeur. Le circuit bistable 12 reste verrouillé sur la valeur précédente.

Une deuxième période P2 débute au front montant (instant t1) du signal CK1 à partir duquel le circuit bistable 12 devient passant et permet la propagation de la donnée mémorisée dans le premier circuit bistable 11 jusqu'à la sortie Q de la bascule maître-esclave.

Au front descendant (instant t2) du signal CK1, le circuit bistable 12 verrouille la donnée (période P3).

Enfin, au front descendant (instant t3) du signal CK2, le circuit bistable 11 se rouvre pour acquérir une nouvelle valeur du signal de données D (période P4).

On voit que, dans les périodes P1 et P3, les circuits bistables 11 et 12 sont tous les deux verrouillés. Toutefois, dans la période P1, ils sont verrouillés sur des valeurs différentes alors que dans la période P3, ils le sont sur la même valeur. Par conséquent, lors d'un fonctionnement correct, la valeur présente au point 35 correspond à la donnée d'entrée dans la période P1 et à la donnée de sortie dans la période P3.

Les périodes P1 et P3 sont utilisées pour détecter l'apparition d'une perturbation. En l'absence de perturbation, l'état du point 35 doit être identique à celui de l'entrée D pendant la période P1 alors qu'il doit être identique à celui de la sortie Q pendant la période P3.

La vérification peut être effectuée n'importe quand dans ces périodes en examinant les états présentés par les signaux V1 et V2.

Une solution particulièrement simple est d'utiliser les signaux CK1 et CK2 (ou S331 et S332) pour déclencher la détection.

Une première vérification est alors effectuée en comparant, à l'instant t1 (front montant du signal CK1 ou front descendant du signal S332) correspondant à la fin de la période P1, les états de l'entrée D et de la sortie NQ1. S'ils sont identiques, cela signifie que la donnée n'a pas été modifiée pendant l'acquisition. En effet, si une perturbation intervient, celle-ci est ponctuelle et ne se traduit pas par une modification des états respectifs mémorisés par les deux circuits bistables. En désynchronisant leur fonctionnement, on autorise une telle détection d'une perturbation dynamique.

Une deuxième vérification est effectuée en comparant, à l'instant t3 (front descendant du signal CK2 ou du signal S331) correspondant à la fin de la période P3, les états de la sortie Q et du point 35. Cela revient à une détection de perturbation statique.

De préférence, les périodes P2 et P4 sont choisies pour être les plus courtes possibles. La durée de la période P2 doit cependant rester supérieure à la durée minimum du niveau haut sur l'entrée de données du circuit bistable 12. La durée de la période P4 doit rester supérieure à la durée minimum de niveau bas sur l'entrée de données du circuit bistable 11. Ces durées minimales dépendent des caractéristiques des circuits bistables et sont connues pour un circuit donné, ce qui permet de générer les signaux CK1 et CK2 de façon appropriée.

La figure 9 représente un mode de réalisation d'un circuit 4 de comparaison et d'interprétation des résultats détectés par les bascules. Dans l'exemple, on suppose que plusieurs bascules d'un même circuit intégré fournissent des signaux V1 et V2 qui sont combinés par des portes OU 41 et 42 avant d'être échantillonnés par des bascules 43 et 44 pour être traités par un circuit 45 (par exemple, un processeur). Dans le cas où une seule bascule maître-esclave est surveillée, les combinaisons 41 et 42 n'ont pas lieu d'être. La bascule 43 est déclenchée par le signal CK1 tandis que la bascule 44 est déclenchée par l'inverse du signal CK2. Le circuit de traitement 45 interprète les détections opérées par les signaux V1 et V2 et prend les contre mesures adaptées.

La figure 10 représente un exemple de système électronique comprenant au moins deux circuits 5 (IC1) et 6 (IC2). Au moins l'un de ces circuits (dans l'exemple le circuit 5) est équipé d'un mécanisme de détection de perturbations accidentelles ou volontaires sur des bascules maître-esclave 3 qu'il comporte entre des blocs logiques. Tout ou partie des bascules intermédiaires à des fonctions logiques sont équipées des fonctionnalités décrites ci-dessus. Les signaux V1 et V2 des bascules sont exploitées par un circuit 4 de décision (DECID) et les signaux déclencheurs CK1 et CK2 sont, par exemple, générés par un circuit 7 de commande (CTRL) à partir d'un signal d'horloge CLOCK du circuit 5.

Il est désormais possible de détecter l'apparition d'une perturbation dans un circuit logique incluant des bascules de synchronisation de type maître-esclave.

La structure proposée pour la bascule maître-esclave permet en outre d'activer ou de désactiver la détection.

Par ailleurs, la présence de plusieurs bascules à détection dans un trajet logique permet de détecter l'apparition d'une perturbation dans tout le trajet logique.

En outre, le fait d'utiliser la sortie NQ1 au lieu de la sortie Q1 pour la comparaison par les portes 341 et 342 améliore la détection en cas d'attaque modifiant de la même façon les états respectifs des deux circuits 11 et 12.

Divers modes de réalisation particuliers de la présente invention ont été décrits. Diverses variantes et modifications sont à la portée de l'homme du métier. En particulier, bien que l'invention ait été plus particulièrement décrite en relation avec des bascules maître-esclave dépourvues d'entrée de réinitialisation ou de mise à 1, elle se transpose sans difficulté à de telles bascules. De plus, bien que deux exemples pratiques de bascules maître-esclave aient été décrits de façon détaillée, l'invention est compatible avec toute bascule de ce type, pourvu que le point intermédiaire entre les deux bistables soit exploitable.

En outre, la génération des signaux de commande CK1 et CK2 n'a pas été détaillée, cette génération étant à la portée de l'homme du métier à partir des indications fonctionnelles données ci-dessus et en utilisant des circuits en eux-mêmes usuels.

Enfin, d'autres circuits logiques peuvent être prévus, pourvu de respecter les fonctionnalités décrites. En particulier, les différents états considérés peuvent être inversés en adaptant les signaux déclencheurs. Par ailleurs, les comparaisons logiques du bloc 34 peuvent le cas échéant être externes à la bascule dont on aura rendu le point intermédiaire accessible.

## Revendications

1. Procédé de détection d'une perturbation de l'état d'une bascule synchrone de type maître-esclave (3) comportant deux circuits bistables (11, 12) en série, **caractérisé en ce que** le procédé comprend les étapes suivantes :
- déclencher les circuits bistables par deux premiers signaux (S331, S332) différents l'un de l'autre ;
- comparer le niveau d'un point intermédiaire (35) de liaison entre les deux circuits bistables à la fois au niveau présent en entrée de la bascule maître-esclave et au niveau présent en sortie de la bascule ; et
- vérifier l'état de la bascule en examinant deux deuxièmes signaux (V1, V2) résultants des comparaisons et fournissant une indication sur la présence d'une éventuelle perturbation.

2. Procédé selon la revendication 1, dans lequel les deuxièmes signaux (V1, V2) sont échantillonnés sur des fronts des premiers signaux.

3. Procédé selon la revendication 1 ou 2, dans lequel les premiers signaux sont générés de telle sorte que les circuits bistables (11, 12) sont commandés cycliquement en quatre périodes successives dans lesquelles :
les deux circuits sont verrouillés ;
seul un premier circuit est verrouillé ;
les deux circuits sont verrouillés ; et
seul un deuxième circuit est verrouillé.

4. Procédé selon la revendication 3, dans lequel les périodes où les deux circuits sont verrouillés fournissent, sur les deuxièmes signaux, des états indicateurs d'une perturbation éventuelle.

5. Procédé selon l'une quelconque des revendications 1 à 4, dans lequel un niveau constant d'un (CK2) des premiers signaux désactive la détection.

6. Circuit électronique incluant :
une bascule synchrone maître-esclave comportant deux circuits bistables (11, 12) en série et deux bornes (CK1, CK2) d'application de signaux déclencheurs différents l'un de l'autre ; et
un premier circuit logique (34) de comparaison du niveau d'un point intermédiaire (35) de liaison entre les deux circuits bistables à la fois au niveau présent en entrée (D) de la bascule et au niveau présent en sortie (Q) de la bascule,
**caractérisé en ce qu'**il comporte un circuit (4) de détection d'une perturbation de l'état de la bascule en examinant deux deuxièmes signaux (V1, V2) résultants des comparaisons.

7. Circuit électronique selon la revendication 6, dans lequel un deuxième circuit logique (33) est intercalé entre les deux bornes (CK1, CK2) d'application des signaux déclencheurs et des bornes de déclenchement respectives des circuits bistables (11, 12).

8. Circuit électronique selon la revendication 6 ou 7, dans lequel le premier circuit logique comporte deux comparateurs (331, 332) comparant respectivement le niveau de l'entrée (D) de la bascule au niveau du point intermédiaire (35), et le niveau du point intermédiaire au niveau de la sortie (Q) de la bascule.

9. Circuit électronique selon la revendication 7, dans lequel le deuxième circuit logique comporte :
une porte (331) de type OU dont les entrées respectives sont reliées aux bornes (CK1, CK2) d'application des signaux déclencheurs et dont une sortie (S331) est reliée à la borne de déclenchement du premier circuit bistable (11) ; et
un inverseur (332) entre une des bornes d'application des signaux déclencheurs et la borne de déclenchement du deuxième circuit bistable (12).

10. Circuit électronique conforme à l'une quelconque des revendications 6 à 9 incluant au moins un bloc (2) de combinaisons logiques et au moins un ensemble de bascules synchrones maître-esclave (3).

11. Circuit électronique selon la revendication 10, dans lequel toutes les bascules (3) ne sont pas commandées en même temps en mode comparaison.

## Claims

1. A method for detecting a disturbance of the state of a synchronous flip-flop of master-slave type (3) comprising two bistable circuits (11, 12) in series, **characterized in that** the method comprises the following steps:
triggering the bistable circuits by two first signals (S331, S332) different from each other;
comparing the level of an intermediary junction point (35) between the two bistable circuits both to the level present at the input of the master-slave flip-flop and to the level present at the output; and
checking the state of the flip-flop by checking two second signals (V1, V2) resulting from the comparisons and providing an indication as to the presence of a possible disturbance.

2. The method of claim 1, wherein the second signals (V1, V2) are sampled on edges of the first signals.

3. The method of claim 1 or 2, wherein the first signals are generated so that the bistable circuits (11, 12) are controlled cyclically in four successive periods in which:
both circuits are latched;
only a first circuit is latched;
both circuits are latched; and
only a second circuit is latched.

4. The method of claim 3, wherein the periods where both circuits are latched provide, on the second signals, states indicative of a possible disturbance.

5. The method of any of claims 1 to 4, wherein a constant level of one (CK2) of the first signals deactivates the detection.

6. An electronic circuit including:
a master-slave synchronous flip-flop comprising two bistable circuits (11, 12) in series, and two terminals (CK1, CK2) of application of triggering signals different from each other; and
a first logic circuit (34) for comparing the level of an intermediary junction point (35), between the two bistable circuits both to the level present at the input (D) of the flip-flop and to the level present at the output (Q) of the flip-flop,
**characterized in that** it comprises a circuit (4) for detecting a perturbance of the state of the flip-flop by checking two second signals (V1, V2) resulting from the comparisons.

7. The electronic circuit of claim 6, wherein a second logic circuit (33) is interposed between the two terminals (CK1, CK2) of application of the triggering signals and respective triggering terminals of the bistable circuits (11, 12).

8. The electronic circuit of claim 6 or 7, wherein the first logic circuit comprises two comparators (331, 332) respectively comparing the level of the input (D) of the flip-flop at the intermediary point (35), with the level of the intermediary point at the output (Q) of the flip-flop.

9. The electronic circuit of claim 7, wherein the second logic circuit comprises:
an OR-type gate (331) having its respective inputs connected to the terminals (CK1, CK2) of application of the triggering signals and having an output (S331) connected to the triggering terminal of the first bistable circuit (11); and
an inverter (332) between one of the terminals of application of the triggering signals and the triggering terminal of the second bistable circuit (12).

10. An electronic circuit in accordance with any of claims 6 to 9, comprising at least one logic combination block (2) and at least one set of master-slave synchronous flip-flops (3).

11. The electronic circuit of claim 10, wherein not all flip-flops (3) are controlled at the same time in comparison mode.

## Patentansprüche

1. Ein Verfahren zum Detektieren einer Störung des Zustandes eines synchronen Flip-Flops der Master-Slave-Bauart (3), welches zwei in Serie geschaltete bistabile Schaltungen (11, 12) aufweist, **dadurch gekennzeichnet, dass** das Verfahren die folgenden Schritte aufweist:
Auslösen (Triggern) der bistabilen Schaltungen, durch zwei erste voneinander unterschiedliche Signale (S331, S332);
Vergleichen des Pegels eines Zwischenverbindungspunktes (35) zwischen den zwei bistabilen Schaltungen sowohl mit dem am Eingang des Master-Slave-Flip-Flops vorhandenen Pegels als auch dem am Ausgang vorhandenen Pegel; und
Überprüfen des Zustandes des Flip-Flops durch Überprüfen von zwei zweiten Signalen (V1, V2), die sich aus Vergleichen ergeben und Liefern einer Anzeige hinsichtlich des Vorhandenseins einer möglichen Störung.

2. Das Verfahren nach Anspruch 1, wobei die zweiten Signale (V1, V2) an den Flanken der ersten Signale getastet werden.

3. Das Verfahren nach Anspruch 1 oder 2, wobei die ersten Signale derart erzeugt werden, dass die bistabilen Schaltungen (11, 12) zyklisch in vier aufeinanderfolgenden Perioden gesteuert werden, in denen:
beide Schaltungen verriegelt (latched) sind;
nur eine erste Schaltung verriegelt ist;
beide Schaltungen verriegelt sind; und
nur eine zweite Schaltung verriegelt ist.

4. Das Verfahren nach Anspruch 3, wobei die Perioden wo beide Schaltungen verriegelt sind an den zweiten Signalen Zustände liefern, die eine Anzeige für eine mögliche Störung bilden.

5. Das Verfahren nach einem der Ansprüche 1 bis 4, wobei ein konstanter Pegel eines (CK2) der ersten Signale die Detektion deaktiviert.

6. Eine elektronische Schaltung, die Folgendes aufweist:
ein Master-Slave-Synchron-Flip-Flop, welches in Serie zwei bistabile Schaltungen (11, 12) und zwei Anschlüsse (CK1, CK2) aufweist, zum Anlegen von Auslöse- oder Triggersignalen, die voneinander unterschiedlich sind; und
eine erste logische Schaltung (34) zum Vergleichen des Pegels eines Zwischenverbindungspunktes (35) zwischen den zwei bistabilen Schaltungen, sowohl mit dem Pegel am Eingang (D) des Flip-Flops und mit dem Pegel vorhanden am Ausgang (Q) des Flip-Flops,
**dadurch gekennzeichnet, dass** die elektronische Schaltung, eine Schaltung (4) aufweist zum Detektieren einer Störung des Zustandes des Flip-Flops durch Prüfen oder Checken von zwei zweiten Signalen (V1, V2), die sich aus den Vergleichen ergeben.

7. Die elektronische Schaltung nach Anspruch 6, wobei die zweite logische Schaltung (33) zwischen den zwei Anschlüssen (CK1, CK2) zum Anlegen der Auslöser- oder Triggersignale und den entsprechenden Auslöse- bzw. Triggeranschlüssen der bistabilen Schaltungen (11, 12) angeordnet ist.

8. Die elektronische Schaltung nach Anspruch 6 oder 7, wobei die erste logische Schaltung zwei Komparatoren (331, 332) aufweist, die jeweils den Pegel des Eingangs (D) des Flip-Flops an dem Zwischenpunkt (35) mit dem Pegel des Zwischenpunkts am Ausgang (Q) des Flip-Flops vergleichen.

9. Elektronische Schaltung nach Anspruch 7, wobei die zweite logische Schaltung Folgendes aufweist:
ein ODER-Typ Gate (331) das mit seinen entsprechenden Eingängen mit den Anschlüssen (CK1, CK2) zur Anlegung der Triggersignale verbunden ist, und mit einem Ausgang (S331) mit dem Auslöser-Trigger-Anschluss der ersten bistabilen Schaltung (11) verbunden ist; und
ein Inverter (332) zwischen einem der Anschlüsse zum Anlegen der Trigger-Signale und dem Trigger-Anschluss der zweiten bistabilen Schaltung (12).

10. Die elektronische Schaltung nach einem der Ansprüche 6 bis 9, wobei mindestens ein logischer Kombinationsblock (2) und mindestens ein Satz von Master-Slave-Synchron-Flip-Flops (3) vorgesehen sind.

11. Die elektronische Schaltung nach Anspruch 10, wobei nicht alle Flip-Flops (3) gleichzeitig in Vergleichsbetriebsart gesteuert werden.
